# DEMANDE DE BREVET EUROPEEN

(11) **EP 2 921 836 A1**
(43) Date de publication de la demande: **23.09.2015**
(21) Numéro de dépôt: 15159675.6
(22) Date de dépôt: 18.03.2015
(51) Int. Cl.: G01L 9/00, G01L 13/02

(54) **Capteur de mesure de pression différentielle microélectromécanique et/ou nanoélectromécanique**

(30) Priorité: 19.03.2014 FR 1452288
(71) Demandeur: Commissariat à l'Énergie Atomique et aux Énergies Alternatives, 75015 Paris (FR)
(72) Inventeur: Robert, Philippe, 38000 Grenoble (FR); Diem, Bernard, 38130 Echirolles (FR); Jourdan, Guillaume, 38000 Grenoble (FR)
(74) Mandataire: Brevalex

(57) **Abrégé**

Capteur de mesure de pression différentielle MEMS et/ou NEMS comportant au moins une première membrane (4) et au moins une deuxième membrane (6), chacune (4, 6) suspendue à un substrat (2), la première membrane (4) ayant une face (4.1) soumise à une pression de référence et une deuxième face (4.2) soumise à une première pression à détecter, la deuxième membrane (6) ayant une première face (6.1) soumise à la pression de référence et une deuxième face (6.2) soumise à une deuxième pression à détecter, une poutre rigide (8) d'axe longitudinal (X) articulée par rapport au substrat par une liaison pivot autour d'un axe (Y), ladite poutre (8) étant solidarisée par une première zone à la première membrane (4) et par une deuxième zone à la deuxième membrane (6) de sorte que la liaison pivot se situe entre la première zone et la deuxième zone de la poutre (8), des moyens de mesure du déplacement de la poutre (8) autour de l'axe (Y), lesdits moyens de mesure étant disposés au moins en partie sur le substrat.

## Description

### DOMAINE TECHNIQUE ET ART ANTÉRIEUR

La présente invention se rapporte à un capteur de mesure de pression différentielle microélectromécanique et/ou nanoélectromécanique.

Un capteur de mesure de pression différentielle permet de mesurer une différence entre deux pressions, les deux pressions pouvant être quelconque.

Dans le domaine de la microélectronique et nanoélectronique il existe plusieurs types de capteur de mesure de pression différentielle.

Le document J. Micromech. Microeng. 22 (2012) 055015 - H Takahashi *et al.* décrit une poutre de type cantilever à détection piézorésistive pour mesurer la différence de pression entre les deux côtés de la poutre. Une différence de pression induit une déflexion de la poutre qui est mesuré au moyen d'une jauge piézorésistive, la variation de résistance électrique est proportionnelle à la différence de pression. Ce capteur est de structure relativement simple, néanmoins du fait de la réalisation de la poutre les deux côtés à des pressions différentes sont en communication. Afin de limiter les fuites entres les deux côtés de la poutre, des entrefers de taille nanométrique sont réalisés, mais il subsiste une fuite entre les deux côtés de la poutre.

Par ailleurs, la ou les jauges piézorésistives sont en contact avec le gaz ou le liquide entrant en contact avec la poutre. Ce capteur peut donc poser des problèmes de fiabilité.

Enfin cette réalisation impose de réaliser des entrées de pression des deux côtés de la poutre, ce qui peut rendre le montage complexe.

Afin d'éviter la présence d'une fuite entre les deux côtés de l'élément sensible, des capteurs de pression différentielle mettent en oeuvre une membrane étanche. Par exemple le document *"*Capacitive differential pressure sensor for harsh environments" - S. T. Moe & Al. - Sensors and Actuators 83 (2000), pp30-33 décrit un capteur de mesure de pression différentielle capacitif comportant un empilement de trois substrats. Un substrat forme la membrane, qui se déforme sous l'effet d'une pression différentielle entre ses deux faces. La membrane forme avec le substrat intermédiaire un condensateur à capacité variable, la mesure de cette capacité permet de déterminer la pression différentielle. Une capacité de référence, qui est insensible à la pression différentielle permet de compenser les variations de capacité provoquées par la pression ambiante et les variations de température. Ce capteur est de réalisation complexe du fait de l'empilement des trois substrats. Par ailleurs, le condensateur à capacité variable est en contact avec l'un des fluides dont on détecte la pression. Ainsi, dans le cas d'un liquide, celui-ci peut provoquer un court-circuit entre les deux plaques du condensateur.

Le document P.D. Dimitropoulos et al. / Sensors and Actuators A 123-124 (2005) 36-43 décrit un capteur de mesure de pression différentielle mettant en oeuvre deux membranes délimitant entre elles une cavité étanche. Une face de chaque membrane est soumise à une pression, la pression différentielle entre les deux faces du capteur induit une déflexion des deux membranes. Les deux membranes forment un condensateur à capacité variable, la mesure de cette capacité permet de déterminer la pression entre les deux faces.

Ce capteur présente l'avantage que le condensateur à capacité variable est protégé de l'environnement extérieur. En revanche, ce capteur de mesure de pression mesure la somme des pressions appliquées sur les deux membranes et non la différence entre les pressions appliquées sur chacune des membranes. En outre, les deux membranes sont distinctes puisqu'elles ne sont pas issues de la même couche et sont réalisées lors d'étapes différentes. Elles peuvent alors présenter des sensibilités différentes et des variations différentes par rapport aux perturbations extérieures, telles que la température, les vibrations... La précision du capteur est ainsi réduite.

En outre, ce capteur impose des entrées de pression des deux côtés de l'ensemble des deux membranes.

### EXPOSÉ DE L'INVENTION

C'est par conséquent un but de la présente invention d'offrir un capteur de mesure de pression différentielle de réalisation simple et robuste.

Le but de la présente invention est atteint par un capteur de mesure de pression différentielle comportant une première membrane soumise à une première pression sur une face et une pression de référence sur une autre face, une deuxième membrane soumise à une deuxième pression sur une face et à la pression de référence sur une autre face et une poutre reliant les deux membranes du côté des faces soumises à la pression de référence, la poutre étant articulée sur un support par une liaison pivot, et des moyens de mesure sensibles au déplacement de la poutre provoqué par la différence des pression vues par les deux membranes.

La liaison pivot est déportée de la poutre rigide. Elle est distincte de la poutre rigide et a une section différente de la section de la poutre rigide Cette liaison pivot est rattachée à la poutre rigide entre les deux zones de fixation aux membranes. L'axe de la liaison pivot est orthogonal à la poutre rigide.

Le capteur offre une grande robustesse puisque les moyens de mesure sont isolés dans les cavités aux pressions de référence, ils ne sont alors pas en contact avec l'environnement extérieur. Les risques de court-circuit et/ou de corrosion sont évités. En outre il permet en prenant les mêmes pressions de référence pour les deux membranes, de mesurer directement la pression différentielle. En effet, la mise en oeuvre de la poutre permet d'annuler la pression statique dans la mesure et ainsi de fournir directement une valeur de pression différentielle. Le capteur selon l'invention présente ainsi un avantage en termes de dynamique de mesure par rapport aux capteurs de pression différentielle mettant en oeuvre des capteurs de pression absolue.

En d'autres termes, on met en oeuvre un élément intermédiaire qui subit les efforts de poussée de chacune des membranes, du fait de son articulation en rotation judicieuse par rapport au substrat, son déplacement en rotation correspond à la différence des forces de poussée subies par les membranes. En mesurant le déplacement en rotation de l'élément intermédiaire on peut en déduire la pression différentielle.

La mise en oeuvre de la poutre peut permettre avantageusement de bénéficier d'un effet de bras de levier permettant d'augmenter la sensibilité du capteur. En effet, dans le cas de moyen de détection à jauges de contraintes reliés à l'axe de rotation de la poutre, l'effort de poussée appliqué par chaque membrane à la poutre est amplifié, il en résulte alors un déplacement amplifiée de la poutre et une contrainte amplifiée dans la ou les jauges. Le capteur présente alors une sensibilité augmentée. Les extrémités longitudinales de la poutre sont en contact permanent avec les membranes. Elles peuvent être solidarisées aux membranes par une liaison rigide ou souple ou être uniquement en contact «glissant » avec les membranes.

En outre la mise en oeuvre de cette poutre articulée et soumise aux efforts de poussée des deux membranes, une mesure capacitive différentielle peut facilement être mise en oeuvre, contrairement aux autres capteurs de mesure de pression différentielle à détection capacitive.

De manière très avantageuse, les deux membranes ont des structures identiques et sont réalisées simultanément. Elles présentent alors des sensibilités proches, voire identiques et subissent les mêmes variations aux perturbations extérieures, telles que les variations de températures, les vibrations. Le capteur peut alors offrir une grande précision.

Le capteur selon l'invention peut être aisément réalisé en technologie de surface, et peut alors être co-intégré avec des capteurs inertiels réalisés par technologie de surface.

La présente invention a alors pour objet un capteur de mesure de pression différentielle MEMS et/ou NEMS comportant au moins une première membrane et au moins une deuxième membrane, chacune suspendue à un substrat, la première membrane ayant une face soumise à une pression de référence et une deuxième face soumise à une première pression à détecter, la deuxième membrane ayant une première face soumise à la pression de référence et une deuxième face soumise à une deuxième pression à détecter, une poutre rigide d'axe longitudinal articulée par rapport au substrat par une liaison pivot autour d'un axe, ladite poutre étant en contact par une première zone à la première membrane et par une deuxième zone à la deuxième membrane de sorte que la liaison pivot se situe entre la première zone et la deuxième zone de la poutre, des moyens de mesure du déplacement de la poutre autour de l'axe, lesdits moyens de mesure étant disposés au moins en partie sur le substrat.

La liaison pivot est située dans un plan parallèle distinct de celui des membranes. Dans le cas de détection parjauge(s) de contrainte, les jauges de contrainte peuvent se situer dans le plan des membranes.

La distance entre le plan de liaison pivot et le plan des membranes correspond sensiblement à l'épaisseur de la poutre divisée par deux, par exemple quelques dizaines de µm.

Les membranes sont disposées sur la même face du substrat. Elles peuvent être disposées dans le même plan ou dans des plans différents, en particulier en cas d'amincissement ou d'épaississement d'une des membranes, par exemple par le dépôt d'une couche supplémentaire.

Le capteur peut comporter un capot délimitant avec le substrat du côté des premières faces d'une première et deuxième membranes au moins une cavité hermétique.

De préférence, les moyens de mesure sont disposés dans la ou les cavités.

L'axe de rotation peut se situer au centre de la poutre et les première et deuxième zones de contact entre la poutre et les première et deuxième membranes respectivement sont alors avantageusement à égales distances de l'axe de rotation.

De préférence, le contact entre la poutre et les membranes a lieu au voisinage du centre des membranes, là où la déformation des membranes est maximale. La zone correspondant au voisinage du centre des membranes dans la présente demande, est la zone qui, à partir du centre de la membrane, a un rayon correspondant à au plus 10% du rayon de la membrane.

La poutre peut être solidarisée aux membranes ou en contact glissant avec celles-ci au niveau des zones de contact.

La première membrane et la deuxième membrane ont avantageusement la même épaisseur et la même surface.

La poutre peut être solidarisée à la première et/ ou la deuxième membrane par une liaison souple suivant l'axe longitudinal de la poutre et rigide suivant une axe de déformation de la première et/ou la deuxième membrane.

Dans un exemple de réalisation, la liaison pivot est réalisée par au moins une poutre parallèle à l'axe de rotation et sollicitée en torsion.

Dans un autre exemple de réalisation, la liaison pivot est réalisée par au moins une poutre parallèle à l'axe longitudinal et sollicitée en flexion.

Il peut être envisagé de réaliser la liaison pivot en combinant une liaison en torsion comportant une ou deux poutres sollicitées en torsion et une liaison en flexion comportant une ou deux poutres sollicitées en flexion.

Selon une caractéristique additionnelle, le capteur peut comporter des moyens pour rigidifier la première membrane et/ou la deuxième membrane, par exemple formés par des zones de surépaisseur sur la première membrane et/ou la deuxième membrane, par exemple disposées radialement ou en nid d'abeille.

Le capteur peut comporter plusieurs premières membranes soumises à la première pression, et/ou plusieurs deuxièmes membranes soumises à la deuxième pression, la poutre étant en contact des premières membranes et des deuxièmes membranes.

Le capteur peut avantageusement comporter au moins une butée disposée en regard de la première membrane et/ou de la deuxième membrane, à l'opposé de la face de la première membrane et/ou de la deuxième membrane soumise à la pression à détecter de sorte à limiter la déformation de la première membrane et/ou de la deuxième membrane. La butée peut être reliée à une connexion électrique. La butée peut ainsi servir d'électrode d'actionnement, par exemple pour réaliser un autotest et /ou d'électrode permettant de mettre la butée au même potentiel que la membrane et d'éviter ainsi les courts-circuits en cas de choc de pression et/ou d'électrode de polarisation pour obtenir un effet de raideur négative, afin de diminuer la raideur du système et d'augmenter sa sensibilité.

Les moyens de mesure peuvent comporter au moins une jauge de contrainte suspendue reliée par une extrémité au substrat par un plot d'ancrage et solidaire de la poutre au voisinage de l'axe de rotation de sorte qu'un déplacement en rotation de la poutre autour de l'axe de rotation applique une contrainte à ladite jauge, ladite jauge présentant un axe disposé au-dessous ou au-dessus de l'axe de rotation.

Cette configuration peut être obtenue avantageusement en amincissant la ou les jauges, par exemple la ou les jauges présentent une épaisseur inférieure ou égale à la demi-épaisseur de l'axe pivot

De préférence, les moyens de mesure comportent deux jauges de contrainte de part et d'autre de l'axe longitudinal de la poutre.

Dans un exemple de réalisation, la ou les jauges de contrainte est ou sont par exemple des jauges piézorésistives, avantageusement en matériau piézorésistif.

Dans un autre exemple de réalisation, la ou les jauges de contrainte est ou sont des jauges résonantes et les moyens de mesure comportent des moyens d'excitation de la jauge résonante et des moyens de mesure de la variation de vibration de la jauge résonante.

Dans un autre exemple de réalisation, les moyens de mesure sont des moyens de mesure capacitive. Les moyens de mesure capacitive peuvent comporter deux paires d'électrodes, un première paire comportant une électrode fixe et une électrode mobile en regard, l'électrode mobile étant portée par la poutre ,et une deuxième paire comportant une électrode fixe et une électrode mobile en regard, l'électrode mobile étant portée par la poutre dans une zone opposée à la zone portant l'électrode mobile de la première paire par rapport à l'axe de rotation. En variante, les moyens de mesure capacitive peuvent comporter deux paires d'électrodes, un première paire comportant une électrode fixe et une électrode mobile en regard, l'électrode mobile étant portée par la première membrane et l'électrode fixe étant porté par une butée en regard de la première membrane, et une deuxième paire comportant une électrode fixe et une électrode mobile en regard, l'électrode mobile étant portée par la deuxième membrane et l'électrode fixe étant portée par la buté en regard de la deuxième membrane.

Un ou des contacts électrique peuvent être réalisés dans la ou les cavités, et une ou des connexions électriques connectées au(x) contacts électriques de type via traversant sont réalisées à travers le capot.

Un ou des contacts électrique peuvent être réalisés en partie dans la ou les cavités et en partie à l'extérieur de la ou les cavités, et une ou des connexions électriques sont connectées au(x) contacts électriques à l'extérieur de la ou des cavités.

La présente invention a également pour objet un ensemble MEMS et/ou NEMS comportant au moins un capteur de mesure de pression différentielle selon l'invention et au moins un capteur inertiel réalisé sur et dans le même substrat.

La présente invention a également pour objet un dispositif de mesure de pression différentielle comportant au moins un capteur de mesure de pression différentielle selon l'invention et un boîtier dans lequel est monté le capteur de mesure de pression différentielle, ledit boîtier comportant deux prises de pression distinctes se connectant chacune audit capteur de mesure de pression différentielle de sorte qu'une prise de pression débouche sur la deuxième face de la première membrane et l'autre prise de pression débouche sur la deuxième face de la deuxième membrane.

Dans un exemple de réalisation, les deux prises de pression peuvent être sur une face du boitier.

Dans un autre exemple de réalisation, les deux prises de pression sont sur deux faces du boitier, opposées par rapport au capteur de mesure de pression. La pression à laquelle est soumise l'une des membranes arrive latéralement, via l'entrefer ménagé par l'épaisseur du cordon de scellement (ouvert au moins partiellement) et/ou par l'intermédiaire d'un espace gravé dans le substrat.

### BRÈVE DESCRIPTION DES DESSINS

La présente invention sera mieux comprise à l'aide de la description qui va suivre et des dessins en annexe sur lesquels :
- les figures 1A et 1B sont des vues de dessus et en coupe le long de la ligne A-A respectivement d'un exemple de réalisation d'un capteur de mesure de pression différentielle à détection par jauge de contrainte piézorésistive suspendue selon l'invention,
- la figure 1C est représentation schématique d'un détail des moyens de mesure par jauge de contrainte suspendue résonante avec excitation capacitive et mesure piézorésistive de la résonance de la jauge,
- la figure 1D est représentation schématique d'un détail des moyens de mesure par jauge de contrainte suspendue résonante avec excitation capacitive et mesure capacitive de la résonance,
- les figures 2A et 2B sont des vues de dessus et en coupe longitudinale le long de la ligne B-B respectivement d'un exemple de réalisation d'un capteur de mesure de pression différentielle à détection capacitive selon l'invention,
- la figure 3 est une vue de dessus d'un exemple de réalisation d'un capteur de mesure de pression comportant une articulation souple suivant l'axe X et rigide suivant l'axe Z entre les membranes et la poutre.
- la figure 4 est une vue de dessus d'un exemple de réalisation d'un capteur de mesure de pression différentielle dans lequel l'axe pivot de la poutre est excentré et les membranes ont des diamètres différents,
- les figures 5A et 5B sont des vues de dessus et en coupe le long de la ligne C-C respectivement d'un autre exemple de réalisation d'un capteur de mesure de pression différentielle comportant des butées,

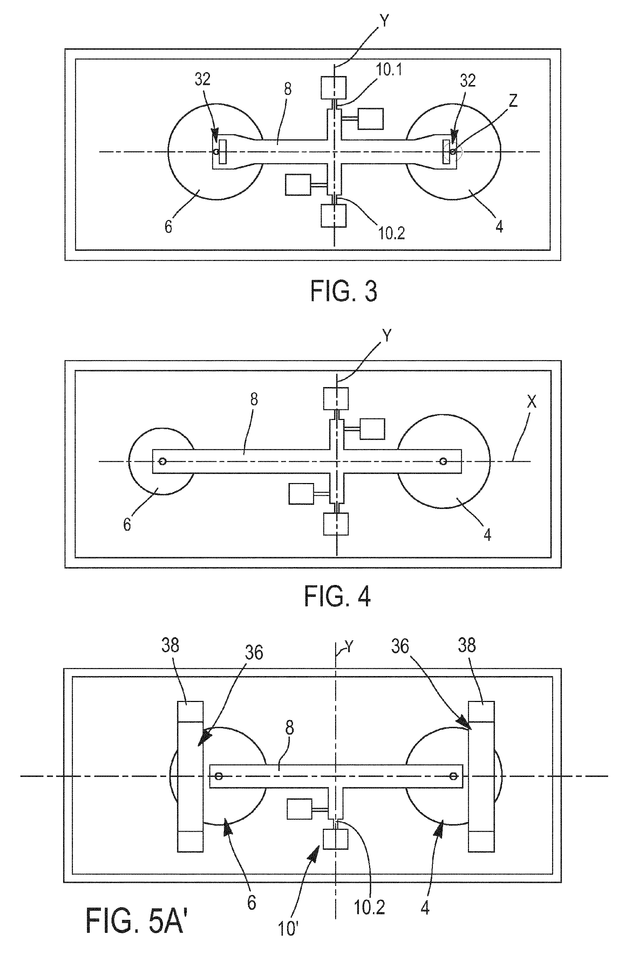

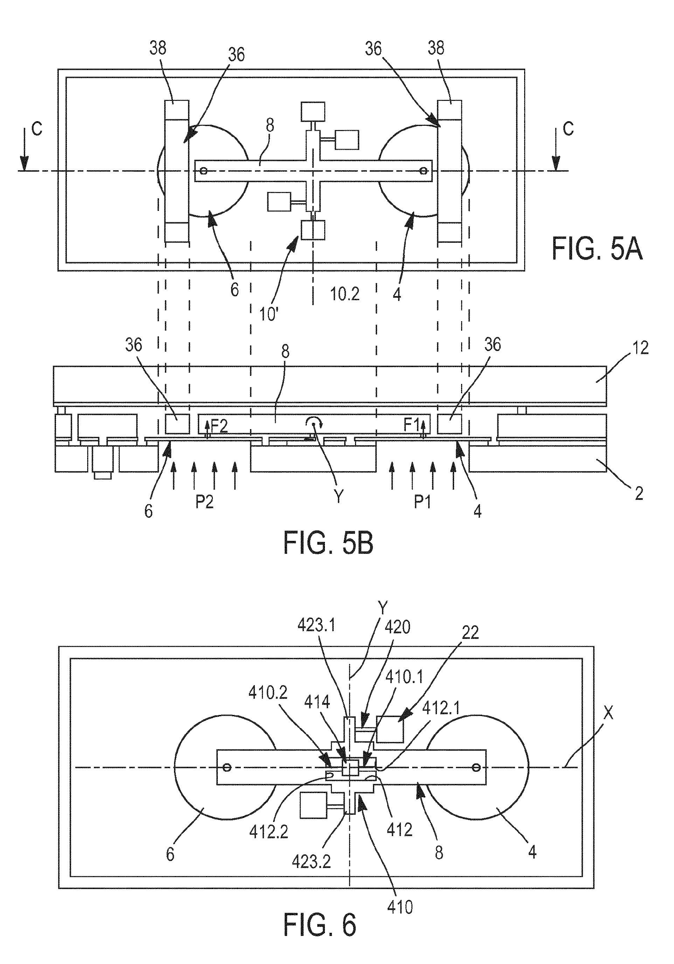

- la figure 5A' est une vue de dessus d'une variante du capteur de la figure 5A dans laquelle la liaison pivot comporte une seule poutre sollicitée en torsion,
- la figure 6 est une vue de dessus d'un exemple de réalisation d'un capteur de mesure de pression différentielle dans lequel l'axe pivot est obtenu par des poutres travaillant en flexion,

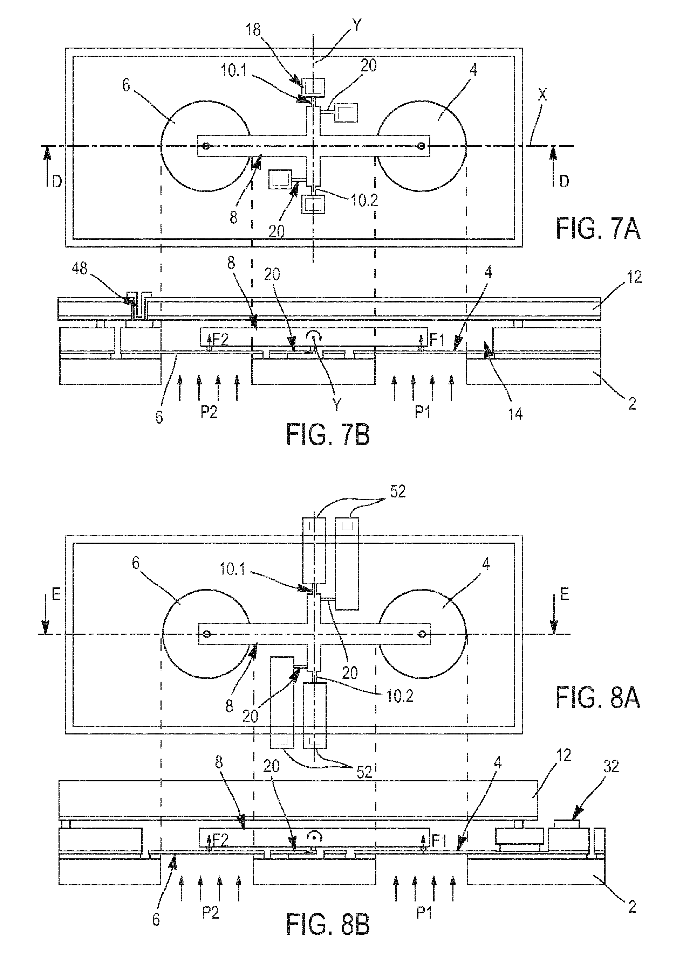

- les figures 7A et 7B sont des vues de dessus et en coupe le long de la ligne D-D respectivement d'un autre exemple de réalisation d'un capteur de mesure de pression différentielle avec un premier exemple de réalisation des contacts électriques,
- les figures 8A et 8B sont des vues de dessus et en coupe le long de la ligne E-E respectivement d'un autre exemple de réalisation d'un capteur de mesure de pression différentielle avec un deuxième exemple de réalisation des contacts électriques,

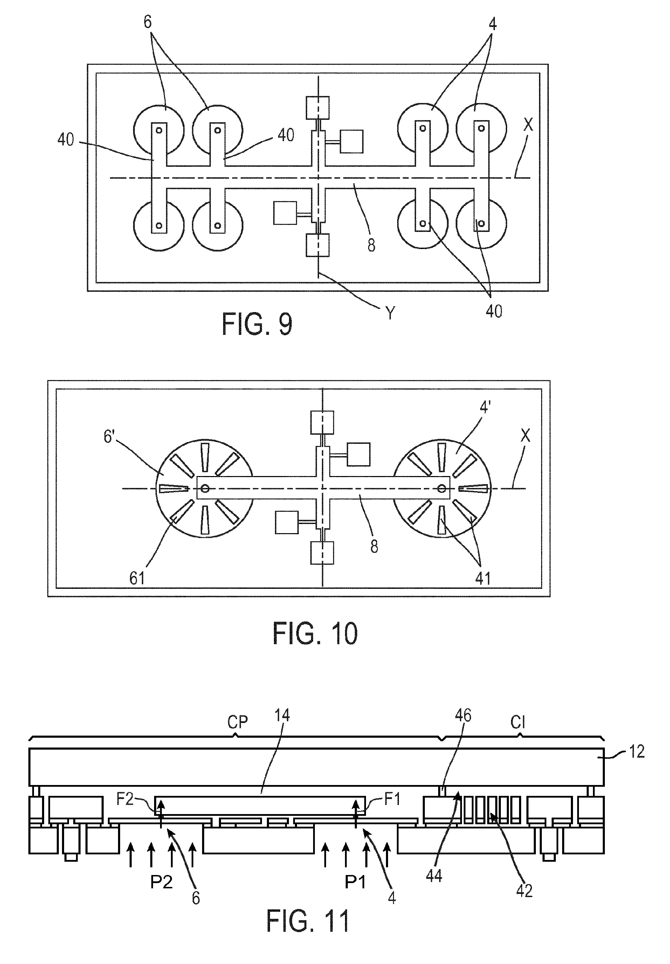

- la figure 9 est une vue de dessus d'un autre exemple de réalisation d'un capteur de mesure de pression différentielle à détection par jauge de contrainte dans lequel plusieurs membranes sont utilisées pour détecter chaque pression,
- la figure 10 est une vue de dessus d'un autre exemple de réalisation d'un capteur de mesure de pression différentielle à détection par jauge de contrainte présentant des éléments de rigidification des membranes pour limiter les déformations parasites
- la figure 11 est une vue en coupe longitudinale d'un ensemble intégrant un capteur de mesure de pression différentielle selon l'invention à et un capteur inertiel,

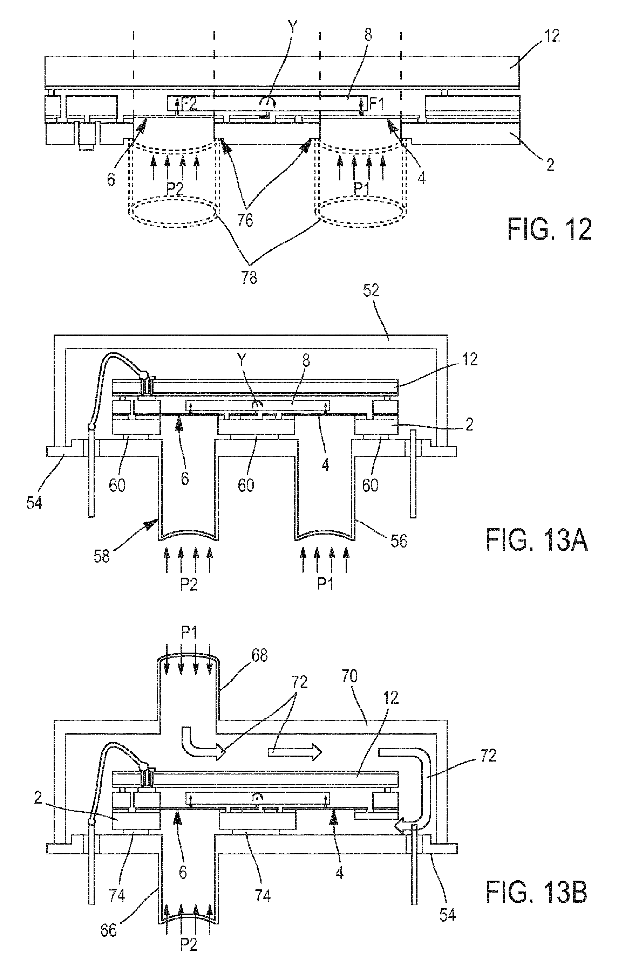

- la figure 12 est une vue en coupe longitudinale d'un autre exemple d'un capteur selon l'invention à montage en boîtier simplifié,
- les figures 13A et 13B sont des vues en coupe longitudinale d'exemple d'assemblage en boîtier d'un capteur de mesure de pression différentielle selon l'invention.

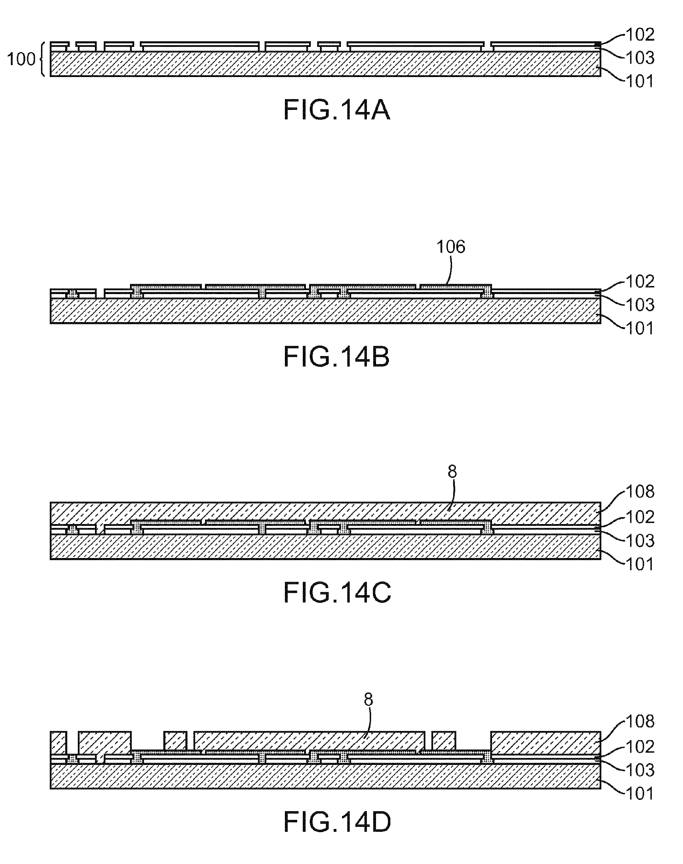

- les figures 14A à 14H sont des vues de dessus et en coupe longitudinale de différentes étapes de réalisation d'un dispositif de mesure de pression selon un exemple de procédé de réalisation.

### EXPOSÉ DÉTAILLÉ DE MODES DE RÉALISATION PARTICULIERS

Dans la description qui va suivre, les capteurs sont de type MEMS et/ou NEMS, cependant ils seront désignés uniquement par le terme "capteur" à des fins de simplicité.

Les éléments et parties ayant la même fonction et la même forme seront désignés par les mêmes références.

Le capteur de mesure de pression différentielle est destiné à mesurer la différence de pression entre des pressions P1 et P2.

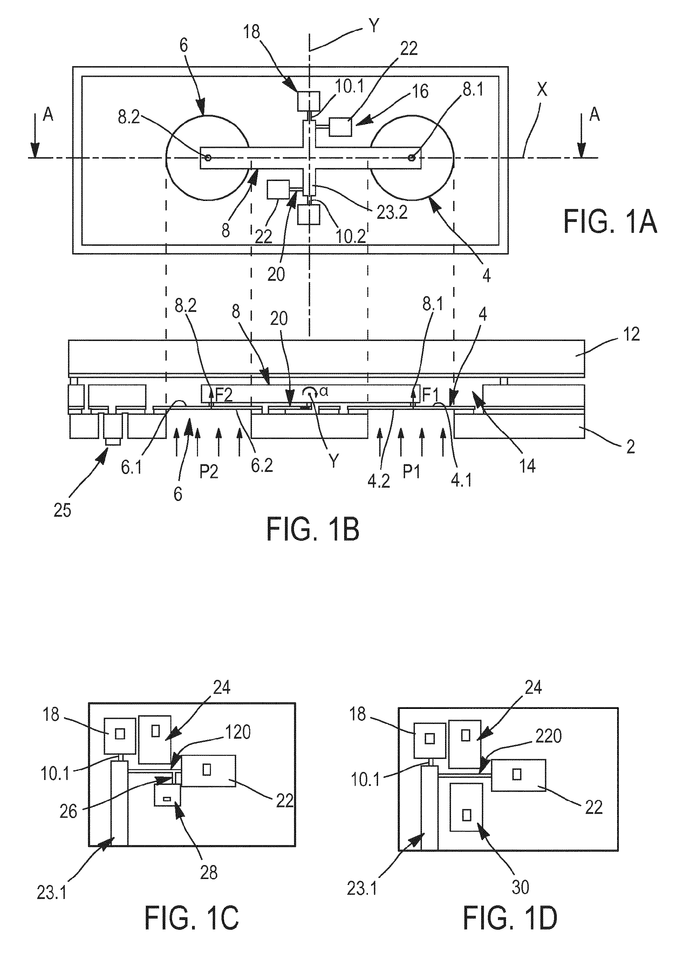

Sur les figures 1A et 1B sont des vues de dessus et en coupe respectivement d'un exemple de réalisation d'un capteur de mesure de pression différentielle, comportant un substrat 2, deux membranes distinctes 4, 6 suspendues sur le substrat.

Chaque membrane 4, 6 est telle qu'elle se déforme sous l'action d'une différence de pression sur ses deux faces.

Dans l'exemple représenté, la membrane 4 est soumise sur une de ses faces 4.1 à une pression de référence REF et sur l'autre de ses faces 4.2 à la pression P1.

La membrane 6 est soumise sur une de ses faces 6.1 à la pression de référence REF et sur l'autre de ses faces 6.2 à la pression P2.

Dans l'exemple représenté, les deux membranes sont soumises à la même pression de référence. Mais un capteur avec des pressions de référence différentes ne sort pas du cadre de la présente invention.

Dans l'exemple représenté, une cavité 14 hermétique aux gaz est ménagée dans laquelle règne la pression de référence PREF.

Dans l'exemple représenté, les membranes 4, 6 ont la forme d'un disque mais elles pourraient présenter toute autre forme, comme une forme carrée, hexagonale... Elles pourraient également avoir des formes différentes l'une de l'autre. De préférence, les membranes sont planes, de préférence sont coplanaires et de préférence sont de même épaisseur.

Une poutre 8 d'axe X est montée articulée autour d'une liaison pivot 10 d'axe Y sur le substrat. L'axe Y est dans l'exemple représenté perpendiculaire à l'axe X. Dans l'exemple représenté, la poutre est à section rectangulaire mais elle pourrait être à section trapézoïdale par exemple. La liaison pivot 10 est déportée de la poutre 8.

Dans l'exemple représenté, la liaison pivot 10 comporte deux poutres 10.1, 10.2 reliant chacune un bord latéral de la poutre 10 à un plot d'ancrage formant avantageusement un contact électrique 18. Les deux poutres sont alignées le long de l'axe Y. Les poutres 10.1, 10.2 sont sollicitées en torsion autour de l'axe Y. La liaison pivot peut comporter une seule poutre sollicitée en torsion comme cela sera décrit ci-dessous.

La poutre 8 est solidarisée par chacune de ses extrémités longitudinales 8.1, 8.2 à la face 4.1, 6.1 de la membrane 4, 6 respectivement. La poutre relie rigidement les deux membranes en comparaison de la raideur des membranes. On peut envisager que la poutre soit solidarisée aux membranes 4, 6 au niveau d'une zone intermédiaire entre son extrémité longitudinale et l'axe de rotation Y.

Nous verrons que dans le cas de moyens de mesure à jauges de contrainte, plus les distances entre les points d'application des forces sur la poutre et l'axe de rotation Y est grande, plus la sensibilité est grande.

Dans la présente demande, on entend par « substrat » par soucis de simplification, le substrat support 2 et les couches disposées sur ce substrat support telles que par exemple la ou les couches dans laquelle ou lesquelles sont réalisées les membranes et la poutre 8.

Un capot 12 est assemblé sur le substrat 2 du côté de la poutre et définit avec le substrat et les membranes la cavité étanche 14 dans laquelle est établie la pression de référence REF. Dans le cas où chacune des membranes serait soumises sur une face à une pression de référence différente, le capot 12 délimiterait deux cavités hermétiques avec chaque membrane et le substrat.

De manière avantageuse, le capot 12 est scellé sur le substrat sous vide par scellement, par exemple par scellement eutectique, anodique, scellement moléculaire ou SDB ("Silicon Direct Bonding" en terminologie anglo-saxone), le scellement moléculaire ou SBD utilisant les forces de surface et forces de Van der Waals),.., ce qui permet d'obtenir une bonne qualité de vide, qui est plus fiable par exemple par rapport à un bouchage par dépôt.

En outre, cette réalisation de la ou des cavités directement par scellement du capot permet d'insérer un matériau getter dans la ou les cavité(s) de référence, par exemple dans le cas où l'on souhaite avoir un vide de référence poussé et stable dans le temps.

Le capteur comporte également des moyens de mesure 16 du déplacement de la poutre autour de l'axe Y, ce qui permet de remonter à la différence ce pression P1-P2. Les moyens de mesure sont déportés par rapport à aux membranes.

Dans l'exemple représenté, les moyens des mesure sont formés par deux jauges de contrainte suspendues 20, situées de part et d'autre de la poutre 8.

Une jauge 20 est suspendue entre un plot d'ancrage 22 et un élément 23.1 d'axe Y aligné avec les poutres de torsion 10.1, 10.2, en saillie d'un bord latéral de la poutre. L'autre jauge 20 est suspendue entre un plot d'ancrage et de contact électrique 22 et un élément 23.2 d'axe Y aligné avec les poutres de torsion 10.1, 10.2, en saillie de l'autre bord latéral de la poutre 8.

Les éléments 23.1, 23.2 sont fixes par rapport à la poutre 8 de sorte que la rotation de la poutre 8 correspond à celle des éléments.

Des contacts électriques 25 sont avantageusement dans les plots d'ancrage permettant d'alimenter les jauges de contrainte. En variante, on pourrait envisager de réaliser des contacts électriques distincts de plots d'ancrage et la réalisation d'une connexion entre les contacts électriques et les jauges.

Dans l'exemple représenté, le contact électrique 25 est réalisé en face arrière du substrat 2. Il correspond aux plots de contact 22, 16, 18. Afin de simplifier la représentation, il est décalé. Mais il est en pratique réalisé à l'aplomb de chacun des contacts électriques du capteur. Le contact électrique en face arrière et est un contact traversant ou via ou TSV (Through Silicon Vias en terminologie anglo-saxonne).

Lors du pivotement de la poutre 8 autour de l'axe Y, les jauges de contraintes 20 sont déformées. La poutre transforme la déflexion différentielle des membranes en une contrainte sur les jauges. La déflexion différentielle est amplifiée grâce à la poutre formant un bras de levier.

La contrainte amplifiée par la poutre 8 s'applique alors sur les extrémités longitudinales de jauges

La raideur en flexion de la poutre hors du plan du substrat de la poutre 8 est de préférence au moins 10 fois supérieure à la raideur en compression de la ou des jauges, ce qui permet d'éviter une déformation de la poutre et une réduction de la déformation transmise à la poutre. Dans l'exemple représenté, les jauges 20 sont disposées de part d'autre de l'axe de rotation Y et de la poutre 8. Les moyens de mesure pourraient ne comporter qu'une seule jauge de contrainte. La mise en oeuvre de deux jauges de contrainte permet d'effectuer des mesures différentielles, rendant le dispositif moins sensible aux variations extérieures, par exemple aux variations de température.

De manière avantageuse, la ou les jauges ont une section nanométrique, ce qui permet d'avoir une concentration de contrainte plus importante et donc une sensibilité accrue.

Sur les figures 1A et 1B, les jauges de contrainte sont de type piézorésistif. La variation de résistance due à la contrainte qui leur est appliquée permet de déduire le déplacement de la poutre autour de l'axe Y et donc la différence de pression P1-P2.

Les jauges sont orientées de sorte que leur axe sensible soit sensiblement parallèle à la poutre et donc qu'il soit sensiblement orthogonal à l'axe de rotation du bras de liaison. Elles sont disposées avantageusement au plus près de l'axe de rotation Y de sorte que l'axe de rotation Y soit proche du point d'application de la contrainte sur les jauges. En effet, l'amplification de la contrainte par le bras de levier est d'autant plus importante que l'axe de rotation est proche du point d'application de la contrainte sur la jauge

Par ailleurs, la ligne neutre de chaque jauge est disposée au-dessus ou au dessous de l'axe de rotation du bras de transmission. Pour cela les jauges peuvent présenter une épaisseur inférieure à celle de la poutre de torsion et/ou de flexion. Par exemple pour obtenir cette épaisseur plus faible à partir des mêmes couches, on peut déposer une surépaisseur sur lesdites poutres.

Sur les figures 1C et 1D, on peut voir des exemples représentés schématiquement de jauges de contrainte de type résonant.

Sur la figure 1C, la jauge résonante 120 est suspendue entre la poutre de torsion 10.1 et le plot d'ancrage 22 formant contact électrique. Une électrode d'excitation 24 est prévue de long d'un flanc de la jauge résonante 120 pour la mettre en vibration. Des moyens de mesure piézorésistifs de la vibration de la jauge résonante 120 sont prévus. Il s'agit dans l'exemple représenté d'une jauge piézorésistive 26 suspendue entre la jauge résonante 120 et un plot d'ancrage 28 comprenant avantageusement un contact électrique.

L'électrode d'excitation met en vibration la jauge résonante 120 et la variation de la fréquence de vibration due à la contrainte qui est appliquée à la jauge résonante 120 est mesurée par la jauge piézorésistive 26.

Sur la figure 1D, la détection de la variation de la fréquence de vibration de la jauge résonante 220 est réalisée de manière capacitive. Les moyens de mesure comportent une électrode d'excitation 24 et une électrode de détection 30 formant avec la jauge résonante 220 un condensateur à capacité variable. La mesure de la variation de capacité est fonction de la variation de fréquence de vibration de la poutre résonante 220 qui dépend de la contrainte qui lui est appliquée.

Nous allons maintenant expliquer le fonctionnement du capteur de mesure de pression des figures 1A et 1B.

Lorsqu'une différence de pression apparait entre la face 4.2 de la membrane 4 et la face 6.2 de la membrane 6, une force F1 s'applique sur l'extrémité 8.1 de la poutre, proportionnelle à la pression P1, et une force F2 s'applique sur l'extrémité 8.2 de la poutre proportionnelle à la pression P2. En considérant que les forces sont d'intensités différentes mais de même sens, par exemple vers l'intérieur de la cavité de pression de référence, la poutre 8 bascule autour de l'axe Y. si P1 est supérieure à P2, la poutre pivote dans le sens antihoraire et si la si P2 est supérieure à P1, la poutre pivote dans le sens horaire.

Ce basculement a pour effet d'appliquer une contrainte aux jauges de contrainte 20, 20. Cette contrainte est amplifiée du fait de l'effet bras de levier. La contrainte subie par les jauges 20, 20 est alors mesurée avec les moyens décrits ci-dessus. Ces mesures permettent alors de déterminer la différence de pression entre P1 et P2.

Dans le cas où la pression de référence est la même pour les deux membranes, le capteur de mesure de pression différentielle permet de fournir directement la pression différentielle P1-P2.

Le capteur de mesure de pression différentielle permet de mesurer des différences de pression que les pressions P1 et P2 soient supérieures ou inférieures ou égales à PREF.

L'amplification de la contrainte par le bras de levier sera d'autant plus importante que la longueur du bras entre le point d'application de la force par les membranes et l'axe de rotation Y sera grande, que l'axe de rotation sera proche du point d'application de la contrainte sur les jauges. La contrainte sera également d'autant plus élevée que la section des jauges (épaisseur, largeur) sera petite.

Ainsi, la sensibilité du capteur est augmentée. Il est donc possible d'offrir des capteurs plus performants ou alors de réduire la taille des capteurs, par exemple en réduisant la surface des membranes, tout en conservant la même performance.

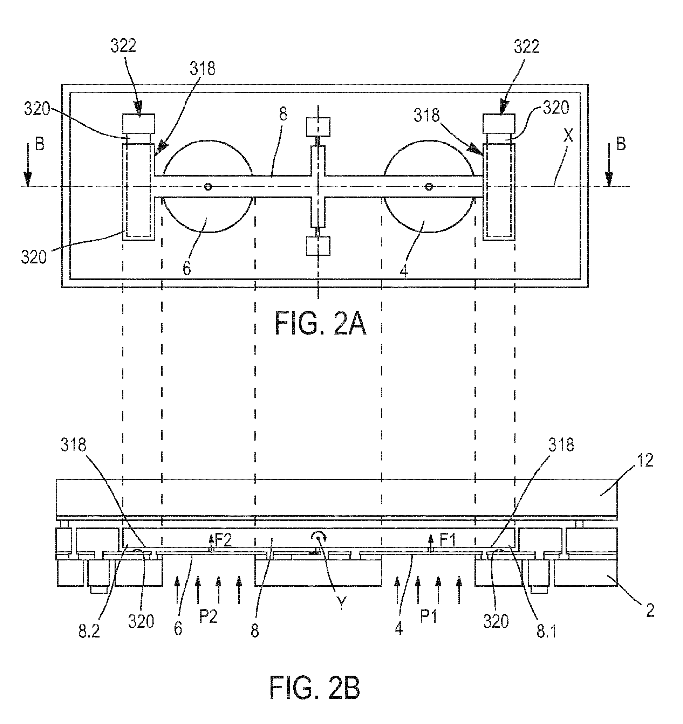

Sur les figures 2A et 2B, on peut voir un autre exemple de réalisation d'un capteur de mesure de pression différentielle dans lequel la détection est de type capacitif. Ces moyens sont déportés par rapport aux membranes.

Ce capteur diffère de celui des figures 1A et 1B, en ce que les moyens de mesure 316 sont de type capacitif.

De manière préférée, il s'agit d'une mesure différentielle. Pour cela, un condensateur à capacité variable est prévu sur chaque bras de la poutre 8 de part et d'autre de l'axe de rotation Y, fournissant deux mesures de capacité. La poutre 8 porte une électrode mobile 318 commune aux deux condensateurs à capacités différentielles; deux électrodes fixes 320 (représentée en pointillés) sont prévus sur le substrat en regard de l'électrode mobile 318 sur les deux bras de la poutre. Chaque électrode fixe est connectée à un contact électrique 322 relié à une source de polarisation et le contact de l'électrode mobile 318 se fait via le contact de la poutre, par exemple au niveau de l'encastrement de l'axe de torsion (plot 18 sur la figure 1A). Les électrodes mobiles 318 ont un déplacement hors-plan et s'écartent ou se rapprochent des électrodes fixes 320. Avantageusement l'électrode mobile 318 est disposée à l'extrémité longitudinale 8.1, 8.2 de la poutre 8 le plus loin de l'axe Y afin d'avoir un déplacement de l'électrode mobile par rapport à l'électrode fixe augmenté et ainsi une sensibilité de mesure augmentée.

En variante, on pourrait prévoir un seul condensateur à capacité variable sur l'un ou l'autre des bras.

L'amplification du déplacement de l'électrode mobile (par rapport à l'électrode fixe) par le bras de levier sera d'autant plus importante que :
- la longueur du bras entre le point d'application de la force par la membrane et l'axe de rotation est petite,
- l'électrode mobile est éloignée de l'axe de rotation Y.

Dans cet exemple, la poutre est solidarisée aux membranes dans une zone intermédiaire entre l'axe de rotation Y et les extrémités longitudinales 8.1, 8.2.

Lorsque les membranes 4, 6 se déforment, la poutre entraîne avec elle les électrodes mobiles, qui se déplacent par rapport aux électrodes fixes. La distance d'entrefer entre les paires électrodes varie, chaque variation d'entrefer est représentative de la contrainte différentielle appliquée par les membranes et donc de la différence de pression P1-P2. Dans le cas d'une détection capacitive, la réalisation d'une mesure différentielle est aisée.

Grâce à la mise en oeuvre de la poutre 8, le déplacement de la ou des électrodes mobiles peut être amplifié par rapport à celui des membranes 4, 6 Ainsi, pour une différence de pression donnée, la variation de capacité est augmentée. La sensibilité du capteur de mesure de pression différentielle est donc augmentée.

De manière avantageuse, le ou les condensateurs à capacité variable peuvent être également utilisés comme moyen d'actionnement pour effectuer un "autotest" ou une auto-calibration du capteur. La mise en oeuvre de ces électrodes peut également permettre d'asservir en position les membranes, et permettre un mode de mesure en asservi. Ce type d'actionnement (fonction "autotest", asservissement) peut avantageusement être couplé au mode de détection piézorésistif décrit précédemment.

Sur la figure 6, on peut voir une variante de réalisation de la liaison pivot 10, dans laquelle la liaison pivot 410 est réalisée au moyen de poutres travaillant en flexion. Pour cela, la poutre comporte un évidement 412 dans la zone où la liaison pivot est à réaliser. L'évidement forme une fenêtre comportant deux bords 412.1, 412.2 opposés perpendiculaires à l'axe X. Deux poutres 410.1, 410.2 sensiblement alignées le long de l'axe X relient un plot d'encastrement 414 aux deux bords 412.1, 412.2. Les poutres 410.1, 410.2 sont dimensionnées de sorte que l'axe de rotation Y se trouve sur le bloc d'ancrage.

La poutre 8 comporte deux saillies latérales 423.1, 423.2 alignées avec l'axe Y auxquelles sont suspendes des jauges de contrainte 420 des moyens de mesure. Les moyens de mesure piézorésistive ou résonante sont similaires à ceux décrits en relation avec les figures 1A à 1D. Plus de deux poutres de flexion, par exemple quatre peuvent être mises en oeuvre. En outre, cette liaison à poutre de flexion peut s'appliquer à un capteur à détection capacitive.

Sur la figure 3, on peut voir un exemple de réalisation d'un capteur de mesure de pression différentielle qui diffère des exemples des figures 1A à 1D et 2A et 2B en ce qu'il comporte avantageusement une articulation souple 32 entre les membrane 4, 6 et la poutre 8. Cette articulation est, de type ressort ou poutre en flexion. Sur la figure 3 il s'agit d'une poutre en flexion 34 qui permet de transmettre entièrement l'effort le long d'un l'axe Z orthogonal aux axes X et Y induit par la déformation des membranes, tout en limitant l'effort parasite le long de l'axe X, i.e. suivant l'axe de la poutre 8 dû à cette déformation. Cette liaison présente une certaine souplesse suivant l'axe X de sorte à ne pas entraver la déformation de la membrane, et une certaine rigidité suivant l'axe Z pour transmettre toute la déformation de la membrane au bras.

Sur la figure 4, on peut voir un exemple de réalisation d'un capteur de mesure de pression différentielle selon l'invention offrant une configuration dissymétrique. Par exemple, la membrane 4 présente une plus grande surface que la membrane 6. Afin de compenser cette différence sur la poutre, l'axe de rotation Y est décalé vers la membrane 4 ce qui a pour effet d'augmenter l'amplification de la force appliquée sur la membrane 6 et facilite le traitement des mesures.

En variante, le capteur pourrait comporter des membranes de surface différente et un axe de pivot au centre de la poutre et inversement des membranes de même surface mais un axe de pivot décentré.

Sur les figures 5A et 5B, on peut voir un autre exemple de capteur de mesure de pression différentielle à détection par jauge de contrainte dans lequel des moyens de butée mécanique sont mis en oeuvre entre les membranes 4, 6 et le capot.

Les butées 36 servent à limiter le déplacement des membranes 4, 6, et donc celui de la poutre 8, pour protéger les jauges de contrainte. En effet, en cas de choc de pression, la pression vue par les membranes peut sortir de la gamme de mesure prévue à la construction, et les membranes 4, 6 via la poutre 8 peuvent appliquer une contrainte supérieure à la contrainte que peut supporter la jauge ou les jauges. Dans l'exemple représenté, les butées sont formées par des poutres d'axe parallèle à l'axe X et ancrées sur le substrat, elles chevauchent les membranes 4, 6.

Il est ainsi possible de fixer simplement le niveau de pression à partir de laquelle le déplacement de la membrane et donc du bras, est limitée, en positionnant les butées 36 plus ou moins proches des zones des membranes présentant la déformation maximale.

On peut envisager que les butées soient au-dessus de la poutre et forment directement une butée pour la poutre, par exemple dans le cas où les butées sont réalisées directement par la capot 12 ou sur le capot au-dessus de la poutre. On peut envisager qu'une seule butée soit mise en oeuvre, par exemple au dessus de la membrane la plus susceptible de voir un choc de pression.

Un contact électrique 38 peut être ajouté sur le plot d'ancrage de la butée afin de contrôler le potentiel de la butée, par exemple la butée peut être au potentiel de la membrane, ce qui permet d'éviter le risque de court-circuit en cas de contact de la membrane sur la butée et le risque d'une attraction électrostatique parasite de la membrane vers la butée.

Alternativement, il peut être envisagé que chaque butée forme une électrode de mesure et/ou d'actionnement pour la membrane en regard, par exemple pour assurer une fonction d'autotest, d'auto-calibration ou encore pour assurer un asservissement en position de la poutre 8. L'asservissement est obtenu en appliquant une force de rappel électrostatique contrecarrant l'effort en pression s'exerçant sur les membranes. L'asservissement permet d'augmenter la gamme de mesure, i.e. la différence de pression maximale à mesurer, pour une sensibilité du capteur donnée.

Sur la figure 5A', on peut voir une variante de la figure 5A dans laquelle la liaison pivot 10' est formée par une seule poutre 10.2 sollicitée en torsion.

Sur la figure 9, on peut voir un autre exemple de réalisation d'un capteur de mesure de pression différentielle dans lequel chaque pression P1, P2 s'applique sur plusieurs membranes 4, 6 respectivement, la poutre 8 étant reliée à chacune des membranes 4.

Dans l'exemple représenté, le capteur comporte deux jeux de quatre membranes 4, 6 disposés de part et d'autre de l'axe Y. Les quatre membranes 4 sont disposées par paire de chaque côté de l'axe X, et les quatre membranes 6 sont disposées par paire de chaque côté de l'axe X.

La poutre 8 comporte deux éléments transversaux 40 parallèles sur chaque bras, s'étendant de part et d'autre de la poutre 14 et reliés au voisinage de leurs extrémités à une membrane 4, 6

Les déformations des quatre membranes 4 appliquent un effort sur un bras de la poutre 8 et les quatre membranes 6 appliquent un effort sur l'autre bras de la poutre 8. La surface totale de quatre membranes étant supérieure à celle d'une seule membrane, la force appliquée sur la poutre, et donc sur les jauges est augmentée. Cette réalisation est particulièrement intéressante pour les capteurs à jauge de contrainte, telles que les jauges piézorésistives ou résonantes.

Ainsi il est possible d'augmenter l'effort appliqué sur la poutre en sommant les efforts appliqués sur plusieurs membranes. Il sera compris que le nombre de membranes soumises à la pression P1 et le nombre de membranes soumises à la pression P2 peuvent être différents l'un de l'autre. Par exemple, on pourrait prévoir plusieurs petites membranes 4 et une seule grande membrane 6 ou inversement.

Sur la figure 10, on peut voir un autre exemple de réalisation d'un capteur de mesure de pression différentielle dans lequel les membranes 4, 6 présentent une rigidité augmentée localement afin de réduire la déformation des membranes 4, 6 au profit des contraintes appliquées sur la poutre et sur la ou les jauges de contrainte. La sensibilité du capteur peut être ainsi optimisée.

Dans l'exemple représenté, les membranes 4', 6' sont rigidifiées localement dans les zones de forte déformation en ajoutant des surépaisseurs radiales 41, 61 sur les membranes 4, 6 présentant une structure similaire à des baleines de parapluie. Une structure en nid d'abeille peut également convenir ou tout autres moyen augmentant la rigidité de la membrane. Le niveau de rigidification est choisi afin d'éviter de rendre le capteur trop sensible aux accélérations. Une seule des deux membranes peut présenter de tels moyens de rigidification.

Sur la figure 11, on peut voir un exemple d'intégration d'un capteur de mesure de pression différentielle selon l'invention et d'un capteur inertiel. Cette intégration est rendue possible par le fait que le capteur de mesure de pression différentielle CP selon l'invention peut être réalisé avec les technologies de réalisation des capteurs inertiels, tels que les accéléromètres ou les gyromètres réalisés en technologie de surface.

Sur la figure 11, on peut voir le capteur de mesure de pression CP différentielle (à gauche sur la représentation de la figure 11) et un capteur inertiel CI (à droite sur la représentation de la figure 11) comportant des peignes capacitifs interdigités 42, réalisé dans le même substrat que celui du capteur de mesure de pression.

Le capteur inertiel pourrait en variante être du type à jauge de contrainte.

Dans l'exemple représenté, l'encapsulation du capteur inertiel CI est obtenue par la réalisation d'une cavité 44 distincte de la cavité 14 du capteur de mesure de pression différentielle, un cordon de scellement 46 les séparant. Il est envisageable de ne réaliser qu'une seule cavité pour les deux capteurs CP et CI, puisque celle-ci est à une pression de référence.

Le capteur de mesure de pression différentielle selon l'invention met en oeuvre des technologies identiques aux technologies de fabrication des capteurs inertiels micro et nanoélectromécaniques à peignes interdigités ou à jauge de contrainte suspendue. Il est alors possible de mutualiser une grande partie des procédés existants et de co-intégrer un capteur de mesure de pression différentielle et un ou des systèmes micro et nanoélectromécaniques.

Sur les figures 7A et 7B, on peut voir une variante de réalisation des connexions électriques. Dans cette variante, les connexions électriques sont réalisées en face avant par des vias 48 (ou TSV (Through-Silicon Via) à travers le capot en face avant du côté opposé par rapport aux membranes et non en face arrière à travers le substrat comme pour les autres exemples représentés. Comme pour le TSV en face arrière, cette variante permet de récupérer les contacts directement à l'intérieur de la ou les cavités.

Sur les figures 8A et 8B, on peut voir une autre variante de réalisation des connexions électriques dans la face avant. Dans cette variante, les contacts électriques 52 sont réalisés de telle manière qu'ils débouchent à l'extérieur de la ou des cavités. Les plots d'ancrage formant contact électrique 52 sont tels qu'ils passent sous le cordon de scellement entre le substrat 2 et le capot 12. L'accès aux contacts électriques est alors obtenu par sciage ou gravure du capot au droit des contacts électrique à l'extérieur du ou des cavités, et les connexions électriques peuvent être aisément réalisées. Ces contacts électriques sont désignés "saw to reveal" en terminologie anglo-saxonne.

Avantageusement, le substrat supportant les membranes 4, 6 comportent sur la face arrière des portées de centrage 76 bordant les ouvertures d'accès aux faces 4.2, 6.2 des membranes 4, 6 pour faciliter le montage des connecteurs 78 d'amener de pression sur les faces 4.2, 6.2 des membranes 4, 6 respectivement (figure 12).

Sur les figures 13A et 13B, on peut voir des exemples d'assemblage du capteur dans un boîtier formant un dispositif de mesure de pression différentielle.

Le boîtier comporte un fond 54 et un couvercle 62.

Sur la figure 13A, l'assemblage comporte un capteur selon l'un des exemples décrits, un fond 54 sur lequel est fixé le capteur de mesure de pression différentielle. Le fond 54 est muni de deux prises de pression 56, 58 qui, lors du montage du capteur, sont en regard des ouvertures d'accès aux membranes 4, 6. Le montage du capteur sur le fond 54 est étanche de sorte à isoler les prises de pression 56, 58, cette étanchéité est obtenue par exemple et de manière avantageuse, directement au moyen d'un cordon de collage ou de brasage 60 entre le fond et la face arrière du substrat.

Le couvercle 62 est scellé sur le fond afin de protéger le capteur. Un contact électrique 64 est réalisé à travers le fond et est connecté par exemple par un fil de connexion à un contact réalisé en face avant de type TSV. Le montage du couvercle sur le fond peut dans cet exemple ne pas être étanche.

Sur la figure 13B, le dispositif de mesure de pression différentielle comporte une prise de pression 66 dans le fond 54 et une autre prise de pression 68 dans le couvercle 70. Lors du montage du capteur sur le fond, seule une étanchéité est réalisée autour de l'ouverture d'accès à la membrane 6 au moyen d'un cordon de collage ou de brasage 74, la membrane 4 voyant la pression qui est schématisée par les flèches 72. Dans cette réalisation, le montage du couvercle 2 sur le fond 54 est étanche puisque c'est le boîtier qui assure l'amenée de la pression P1 sur la membrane 4. En variante, un conduit pourrait être rapporté dans le couvercle 12 et relié la prise de pression 66 à l'ouverture d'accès à la membrane 4, rendant alors inutile un montage étanche du couvercle sur le capot.

Par exemple, la communication entre la première membrane 4 et la prise de pression 68 est réalisée par gravure de la face arrière du substrat et/ou par ouverture du cordon de fixation du capteur sur le fond. Dans le cas où la section de passage laissée par l'ouverture du cordon de scellement n'est pas suffisante pour avoir des pertes de charge acceptables, il peut être prévu de réaliser un évent supplémentaire par gravure du substrat pour augmenter la section de passage totale.

Il sera compris que les dispositifs des figures 13A et 13B peuvent comporter un capteur avec des contacts électriques en face arrière ou en face avant du type "saw to reveal".

Les variantes de réalisation ont été décrites en considérant un capteur de mesure de pression à détection par jauge de contrainte piézorésistive, mais les variantes des figures 3, 4, 5A, 5B, 6, 7A, 7B, 8A, 8B, 9, 10, 11, 12, 13A, 13B s'appliquent à des capteurs de mesure de pression différentielle à détection capacitive représentés sur les figures 2A et 2B et à des capteurs de pression à jauge de contrainte résonante représentés sur les figures 1C et 1D.

En outre, les différentes variantes peuvent être combinées entre elles sans sortir du cadre de la présente invention.

Il sera compris que de manière préférée le capteur de mesure de pression différentielle présente une structure symétrique en particulier des membranes, de la poutre..., afin de simplifier le traitement des mesures fournies par les moyens de mesure.

Grâce à la mise en oeuvre de deux membranes et d'un élément rigide de liaison entre les deux membranes, il est possible de remonter à une « vraie » mesure différentielle de pression, en annulant la pression de statique commune. La dynamique de mesure est alors notablement augmentée par rapport à un dispositif utilisant deux capteurs de pression absolue.

Le capteur selon l'invention allie à la fois les avantages des capteurs de pression absolue dans lesquels les moyens de mesure sont protégés et les avantages de capteurs de pression relative en termes de dynamique de mesure. De plus dans le cas où la pression de référence est un vide de référence, les dérives thermiques sont limitées.

Grâce à l'invention, les moyens de mesure sont isolés du milieu extérieur, par exemple il n'y a plus de risque de dérive de la capacité ou de court-circuit dans le cas de moyens de mesure capacitifs. Le capteur de mesure est alors plus robuste et plus fiable.

De plus, grâce à la poutre de liaison qui peut servir de bras d'amplification ; un gain en sensibilité important est obtenu, ce qui permet de réaliser un capteur plus performant ou plus petit.

En outre, les membranes et les moyens de mesure sont découplés, ce qui permet une optimisation séparée de ces deux parties du capteur.

Les capteurs selon l'invention permettent de faire une mesure différentielle, aussi bien dans le cas de l'utilisation de moyens de mesure piézorésistive, que capacitive ou résonante. Cette mesure différentielle permet d'augmenter le rapport signal/bruit et de limiter la sensibilité thermique du capteur.

Dans le cas particulier de moyens de mesure capacitifs, lorsque l'entrefer électrostatique est défini par une couche sacrificielle entre chacune des membranes et l'électrode fixe, il est possible d'avoir un bon contrôle de celui-ci.

En outre, puisque les électrodes mobiles sont portées par la poutre de liaison et les électrodes fixes sont portées par le substrat, il est possible d'avoir un volume de la ou des cavités sous vide important, offrant un large volume de référence, donc un vide de référence susceptible d'être plus stable et plus poussé que ceux dans les capteurs conventionnels.

En outre, il est aisé de prévoir des butées mécaniques assurant une protection en cas de surpression, de coup de bélier...

Comme cela a été déjà mentionné, cette structure est équilibrée et est insensible aux accélérations

Le capteur selon l'invention offre en outre l'avantage de pouvoir réaliser les au moins deux membranes sur la même couche et suivant les mêmes étapes. On obtient alors des membranes ayant propriétés mécaniques proches voire identiques.

Nous allons maintenant décrire un exemple de procédé de réalisation du capteur de mesure de pression à détection par jauges de contraintes des figures 1A et 1B, à l'aide des figures 14A à 14H, chaque figure représente l'élément en vue de dessus et en coupe.

Les emplacements de différentes parties du capteur de mesure de pression, en cours de réalisation dans les différentes étapes représentées, sont désignés par les références de ces parties.

Il s'agit d'un procédé de réalisation en technologie de surface i.e. par dépôt et usinage successifs de couches minces sur un substrat de base.

On part d'un substrat SOI 100 (Silicon on Insulator) comportant un substrat 101, un couche d'oxyde 103 et une couche supérieure de silicium 102 a une épaisseur comprise entre quelques centaines de nm et quelques µm. La couche d'oxyde du substrat SOI est désignée 101.

On effectue une étape de lithographie afin de définir les jauges de contrainte, l'axe de torsion, le contour des membranes 4, 6, le contour des zones de contact et d'encastrement des jauges et de l'axe de torsion et l'ouverture de la reprise de contact en face arrière. Sur la figure 14A, des ouvertures au niveau des contacts des plots d'encastrement sont réalisés ce qui permet de faire remonter les contacts électriques entre le substrat 101 et la couche active 102 lors de l'étape d'épitaxie, suite à la gravure de l'oxyde dans ces ouvertures

On effectue ensuite une gravure de la couche de silicium avec arrêt sur la couche d'oxyde 103. La résine restante est éliminée.

On effectue ensuite une gravure de la couche d'oxyde103 avec arrêt sur le substrat.

On obtient l'élément représenté sur la figure 14A.

Lors d'une étape suivante, on effectue un dépôt d'une couche de SiO₂ 106, dont l'épaisseur peut être comprise entre 1µm et 3µm. On effectue ensuite une lithographie pour protéger les jauges de contrainte, les membranes 4, 6, et définir l'ouverture des zones de contact et des plots d'encastrement des jauges et de l'axe de torsion, et l'ouverture des zones d'ancrage 64 de la poutre 8 sur les membranes 4, 6. Une gravure de la couche 106 a ensuite lieu avec arrêt sur le silicium de la couche 102 et sur le silicium 101 du substrat SOI. La résine restante est éliminée. L'élément ainsi obtenu est visible sur la figure 14B.

Lors d'une étape suivante, a lieu la formation d'une couche 108 de silicium, monocristallin ou polycristallin, par exemple par épitaxie ayant typiquement une épaisseur comprise entre 1µm et quelques dizaines de µm. Un abrasion et un polissage mécano-chimique de la couche 108 peut être réalisé. L'élément obtenu est visible sur la figure 14C.

Lors d'une étape suivante, on effectue une lithographie sur la couche 108 afin de définir la zone d'ouverture des membranes 4, 6, et la zone d'ouverture des jauges 20, et de définir la poutre de liaison 8 et les zones d'isolation des contacts. On effectue ensuite une gravure de la couche 108 avec arrêt sur la couche de SiO₂ 106. La résine restante est éliminée. L'élément obtenu est visible sur la figure 14D.

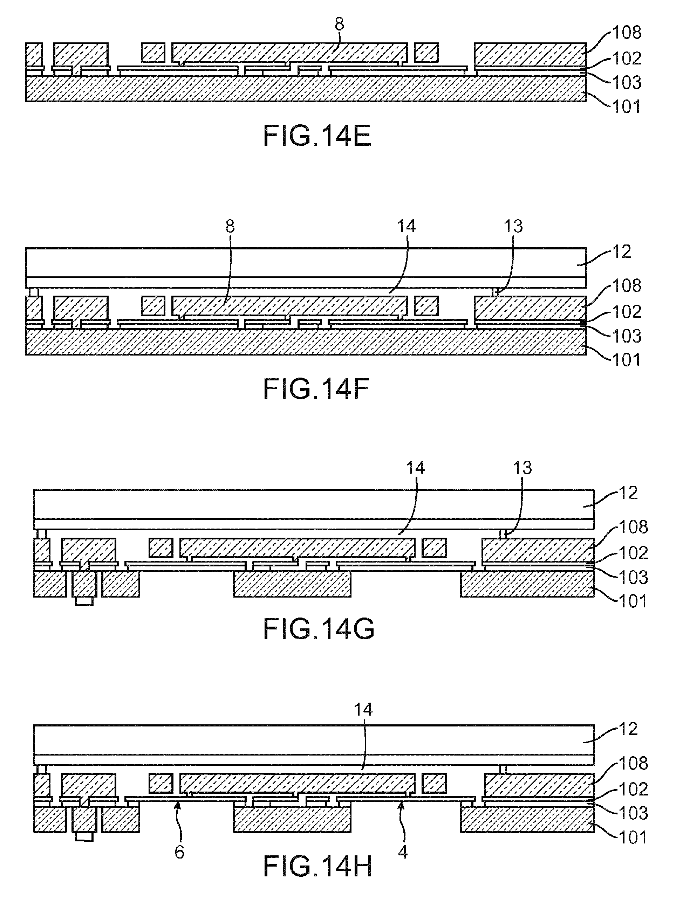

Lors d'une étape suivante, on libère la poutre de liaison 8, l'axe de torsion et les jauges par gravure par exemple au moyen d'acide fluorhydrique vapeur. Lors de cette étape, la couche 106 est entièrement gravée ainsi qu'une partie de la couche de SiO₂ du substrat SOI. Lors de cette étape, les membranes 4, 6 ne sont pas encore libérées. L'élément obtenu est visible sur la figure 14E.

Lors d'une étape suivante, on effectue le scellement sous vide du capot 12 au moyen d'un cordon 13. En variante, le scellement peut être par exemple de type eutectique, SDB ou anodique dans le cas d'un capot en verre, i.e. sans cordon, le scellement étant obtenu par adhésion directe des deux surfaces 12 et 108. Une cavité 14 est délimitée entre le capot 12 et l'élément de la figure 14D.

Le capot peut avoir été préalablement préparé. La préparation du capot peut comporter les étapes de réalisation d'une cavité, du dépôt de getter, de réalisation de routages électriques voire d'une électronique (co-integration CMOS) dans le cas d'un scellement eutectique,...

La cavité étanche autour des membranes est alors formée.

On réalise ensuite un amincissement du substrat par exemple par abrasion en face arrière ou "back-grinding" et polissage mécano-chimique. L'élément obtenu est visible sur la figure 14F.

Lors d'une étape suivante, on effectue un dépôt d'une couche métallique sur la face arrière du substrat afin de réaliser le contact en face arrière. Ensuite, une lithographie est effectuée sur cette couche pour délimiter le contact en face arrière et enfin une gravure de la couche métallique est réalisée. La résine sur la couche métallique restante est éliminée. Une nouvelle lithographie est réalisée en face arrière pour délimiter la zone d'isolation des contacts et l'ouverture des membranes 4, 6 ainsi qu'une gravure du substrat en face arrière, par exemple par gravure profonde par ions réactifs ou DRIE ("deep reactive-ion etching" en anglais) avec un arrêt sur la couche d'oxyde 103 du substrat SOI. La résine restante est éliminée. L'élément obtenu est visible sur la figure 14G.

Enfin, on effectue une gravure en face arrière de la couche d'oxyde 103 du substrat SOI. Les membranes sont libérées. L'élément obtenu est visible sur la figure 14H.

En variante, il est envisageable d'utiliser à la place d'un substrat SOI un substrat standard, sur lequel un dépôt d'une couche sacrificielle, par exemple d'oxyde, a été effectué, ainsi qu'un dépôt d'une première couche de polysilicium ou de SiGe-Poly. Les étapes suivantes sont similaires à celles décrites en partant d'un substrat SOI.

Les valeurs des épaisseurs sont données uniquement à titre d'exemple. D'une manière générale, les couches sacrificielles (en oxyde) sont comprises entre quelques dizaines de nm et quelques microns, et les couches actives, comme le Si, SiGe, ... sont comprises entre quelques dizaines de nm et quelques dizaines de µm.

Le capteur de mesure de pression selon l'invention peut être utilisé dans tous les domaines où une mesure de pression différentielle est requise, par exemple dans le domaine médical, en vue de déterminer les échanges respiratoires ou gazeux. Il peut également être utilisé dans le domaine du génie climatique, dans le but de contrôler les flux d'air. Grâce à un étranglement artificiel dans la conduite du flux, réalisé par exemple au moyen d'un élément laminaire ou d'un diaphragme, il est possible d'obtenir une chute de pression indicative du débit. Les capteurs de pression différentielle mesurent la pression en amont et en aval de l'élément. Le capteur selon l'invention peut également être utilisé dans en milieu industriel ou automobile ou avionique : pour la surveillance des filtres par exemple en utilisant le principe de mise pour contrôler le flux d'air en génie climatique. Si le filtre s'obstrue au fil du temps, il offre une résistance plus forte au passage du flux, et la différence de pression aux bornes du filtre augmente. Les capteurs de mesure de pression différentielle peuvent mesurer cette différence de pression et déclencher des alarmes dès que des valeurs critiques sont atteintes.

## Revendications

1. Capteur de mesure de pression différentielle MEMS et/ou NEMS comportant au moins une première membrane (4) et au moins une deuxième membrane (6), chacune (4, 6) suspendue à un substrat (2), la première membrane (4) ayant une face (4.1) soumise à une pression de référence et une deuxième face (4.2) soumise à une première pression à détecter, la deuxième membrane (6) ayant une première face (6.1) soumise à la pression de référence et une deuxième face (6.2) soumise à une deuxième pression à détecter, une poutre rigide (8) d'axe longitudinal (X) articulée par rapport au substrat par une liaison pivot autour d'un axe (Y) situé dans un plan parallèle aux première et deuxième membranes, ladite poutre (8) étant en contact par une première zone à la première membrane (4) et par une deuxième zone à la deuxième membrane (6) de sorte que la liaison pivot se situe entre la première zone et la deuxième zone de la poutre (8) dans un plan distinct de celui des première et deuxième membranes, des moyens de mesure (16) du déplacement de la poutre (8) autour de l'axe (Y), lesdits moyens de mesure étant disposés au moins en partie sur le substrat, le capteur de mesure comportant également un capot (12) délimitant avec le substrat du côté des premières faces (4.1, 6.1) d'une première (4) et deuxième (6) membranes au moins une cavité hermétique (14), les moyens de mesure (16) étant disposés dans la au moins une cavité hermétique (14).

2. Capteur de mesure de pression selon la revendication 1, dans lequel l'axe de rotation (Y) se situe au centre de la poutre (8) et les première et deuxième zones de contact entre la poutre (8) et les première (4) et deuxième (6) membranes respectivement sont à égales distances de l'axe de rotation (Y).

3. Capteur de mesure de pression selon la revendication 1 ou 2, dans lequel le contact entre la poutre et les membranes a lieu au voisinage du centre des membranes.

4. Capteur de mesure de pression selon l'une des revendications 1 à 3, dans lequel la poutre est solidarisée aux première et deuxième membranes par les première et deuxième zones respectivement.

5. Capteur de mesure de pression selon l'une des revendications 1 à 4, dans lequel la poutre (8) est solidarisée à la première (4) et/ ou la deuxième (6) membrane par une liaison souple suivant l'axe longitudinal (X) de la poutre et rigide suivant une axe (Z) de déformation de la première (4) et/ou la deuxième (6) membrane.

6. Capteur de mesure de pression différentielle selon l'une des revendications 1 à 5, dans lequel la liaison pivot est réalisé par au moins une poutre parallèle à l'axe de rotation (Y) et sollicitée en torsion ou la liaison pivot est réalisée par au moins une poutre parallèle à l'axe longitudinal (X) et sollicitée en flexion.

7. Capteur de mesure de pression différentielle selon l'une des revendications 1 à 6, comportant des moyens pour rigidifier la première membrane et/ou la deuxième membrane, par exemple formés par des zones de surépaisseur sur la première membrane (4) et/ou la deuxième (6) membrane, par exemple disposées radialement ou en nid d'abeille.

8. Capteur de mesure de pression différentielle selon l'une des revendications 1 à 7, comportant au moins une butée disposée en regard de la première membrane (4) et/ou de la deuxième membrane (6), à l'opposé de la face de la première membrane (4) et/ou de la deuxième membrane (6) soumise à la pression à détecter de sorte à limiter la déformation de la première membrane (4) et/ou de la deuxième membrane (6), ladite butée étant avantageusement reliée à une connexion électrique.

9. Capteur de mesure de pression différentielle selon l'une des revendications 1 à 8, dans lequel les moyens de mesure (16) comportent au moins une jauge de contrainte (20) suspendue reliée par une extrémité au substrat par un plot d'ancrage (22) et solidaire de la poutre (8) au voisinage de l'axe de rotation (Y) de sorte qu'un déplacement en rotation de la poutre (8) autour de l'axe de rotation (Y) applique une contrainte à ladite jauge, ladite jauge présentant un axe disposé au-dessous ou au-dessus de l'axe pivot, les moyens de mesure (16) comportant avantageusement deux jauges de contrainte (20) de part et d'autre de l'axe longitudinal (X) de la poutre (8).

10. Capteur de mesure de pression différentielle selon la revendication 9, dans lequel la ou les jauges de contrainte (20) est ou sont des jauges piézorésistives.

11. Capteur de mesure de pression différentielle selon la revendication 9, dans lequel la ou les jauges de contrainte est ou sont des jauges résonantes et dans lequel les moyens de mesure comportent des moyens d'excitation de la ou des jauges résonantes et des moyens de mesure de la variation de vibration de la ou des jauges résonantes.

12. Capteur de mesure de pression différentielle selon l'une des revendications 1 à 8, dans lequel des moyens de mesure sont des moyens de mesure capacitive.

13. Capteur de mesure de pression différentielle selon la revendication 12, dans lequel les moyens de mesure capacitive comportent deux paires d'électrodes, un première paire comportant une électrode fixe et une électrode mobile en regard, l'électrode mobile étant portée par la poutre ,et une deuxième paire comportant une électrode fixe et une électrode mobile en regard, l'électrode mobile étant portée par la poutre dans une zone opposée à la zone portant l'électrode mobile de la première paire par rapport à l'axe de rotation (Y).

14. Capteur de mesure de pression différentielle selon la revendication 8 et la revendication 12, dans lequel les moyens de mesure capacitive comportent deux paires d'électrodes, un première paire comportant une électrode fixe et une électrode mobile en regard, l'électrode mobile étant portée par la première membrane et l'électrode fixe étant porté par une butée en regard de la première membrane, et une deuxième paire comportant une électrode fixe et une électrode mobile en regard, l'électrode mobile étant portée par la deuxième membrane et l'électrode fixe étant portée par la buté en regard de la deuxième membrane.

15. Capteur de mesure de pression différentielle selon l'une des revendications 1 à 14, dans lequel un ou des contacts électrique (54) sont réalisés en partie dans la ou les cavités (14) et en partie à l'extérieur de la ou les cavités, et dans lequel une ou des connexions électriques sont connectées au(x) contacts électriques à l'extérieur de la ou des cavités.

16. Ensemble MEMS et/ou NEMS comportant au moins un capteur de mesure de pression différentielle selon l'une des revendications 1 à 15 et au moins un capteur inertiel réalisé sur et dans le même substrat.

17. Dispositif de mesure de pression différentielle comportant au moins un capteur de mesure de pression différentielle selon l'une des revendications 1 à 15et un boîtier dans lequel est monté le capteur de mesure de pression différentielle, ledit boîtier comportant deux prises de pression distinctes se connectant chacune audit capteur de mesure de pression différentielle de sorte qu'une prise de pression débouche sur la deuxième face de la première membrane et l'autre prise de pression débouche sur la deuxième face de la deuxième membrane.
